# EUROPEAN PATENT SPECIFICATION

(11) **EP 0 446 657 B1**
(45) Date of publication and mention of the grant of the patent: **26.07.1995**
(21) Application number: 91102324.0
(22) Date of filing: 19.02.1991
(51) Int. Cl.: C23C 14/22, C23C 14/34, C23C 14/56, C23C 14/02

(54) **Method for preparing a shield to reduce particles in a physical vapor deposition chamber**
Verfahren zur Vorbereitung einer Blende zur Verminderung von Teilchen in einer Kammer zur physikalischen Aufdampfung
Méthode de préparation d'un écran pour limiter les particules dans une chambre de dépôt physique en phase vapeur

(30) Priority: 02.03.1990 US 487567
(43) Date of publication of application: 18.09.1991
(73) Proprietor: APPLIED MATERIALS, INC., Santa Clara, California 95052-8039 (US)
(72) Inventor: Talieh, Humoyoun, Santa Clara, California 95054 (US); Gilboa, Haim, Palo Alto, California 94306 (US); Mintz, Donald M., Sunnyvale, California 94087 (US)
(74) Representative: Kahler, Kurt, Dipl.-Ing.

(56) References cited:
- EP-A- 0 304 895
- FR-A- 2 088 659
- FR-A- 2 147 265
- PATENT ABSTRACTS OF JAPAN, vol. 10, no. 123 (C-344)[2180], 8th May 1986; & JP-A-60 248 876 (HITACHI SEISAKUSHO) 09-12-1985
- PATENT ABSTRACTS OF JAPAN, vol. 12, no. 438 (C-544)[3285], 17th November 1988; & JP-A-63 162 861 (TOSHIBA) 06-07-1988

## Description

The present invention concerns the preparation of shields in a physical vapor deposition chamber in order to increase shield adhesion and thereby achieve particle reduction.

In physical vapor deposition (PVD) processes a target material, for example Titanium Tungsten, is bombarded by gaseous ions, for example Argon ions. Material from the target is dislodged and sputters onto a work piece. The work piece is generally a semiconductor wafer, but may be, for example, a magnetic disk or a flat panel display.

A PVD chamber generally includes shields in the area immediately around a wafer. The shields prevent excess material sputtering from the target from contaminating the remainder of the PVD chamber.

For many types of sputtered materials, the build-up of excess material on the shields eventually results in flaking. At this point it is usually necessary to service the PVD chamber by replacing the shield. If shield replacement needs to be done at approximately the same time as target replacement, the service to shield may be performed without loss of operation time. However, if the shield needs to be replaced much more often than the target this can result in extra down-time of a system which can seriously impair production throughput. It is desirable, therefore, to seek ways to reduce flaking and thereby lengthen the time between shield replacement.

The above mentioned problems have been overcome with the methods as claimed in claims 1 and 5. The invention further relates to a physical vapor deposition chamber as claimed in claims 10 and 12.

### Summary of the Invention

In accordance with the preferred embodiment of the present invention, a method is presented for preparing a shield for use in a physical vapor deposition process. The shield is sputter-etch cleaned to increase adhesion of deposits in the physical vapor deposition process. The sputter-etch cleaning serves to loosen contamination, such as oxides of the shield material, which may form a diffusion barrier and prevent the deposits from bonding to the shield. Also, the sputter-etch cleaning creates a high degree of surface roughness. This roughness allows for an increase in the ability of a sputtered film to mechanically adhere to the shield.

In addition to sputter-etch cleaning the shield may first be bead blasted. The bead blasting makes the surface of the shield irregular. This enhances interface crack propagation of deposited material on a submicroscopic scale and hinders the flaking of deposited material. This is because the surface irregularities force a fracture propagating along a plane of weakness to often change direction or pass through a stronger region.

### Brief Description of the Drawings

Figure 1 is a simplified block diagram showing a physical vapor deposition chamber used for a sputter deposition process.

Figure 2 shows a perspective view of a disassembled physical vapor deposition chamber in accordance with the preferred embodiment of the present invention.

Figure 3 shows a physical deposition chamber arranged to sputter-etch clean a shield in accordance with a preferred embodiment of the present invention.

Figure 4 shows a physical deposition chamber in which an RF power signal is placed on a lid for in situ reactive or non-reactive plasma treatment of a shield and a clamping ring in accordance with an alternate embodiment of the present invention.

### Description of the Preferred Embodiment

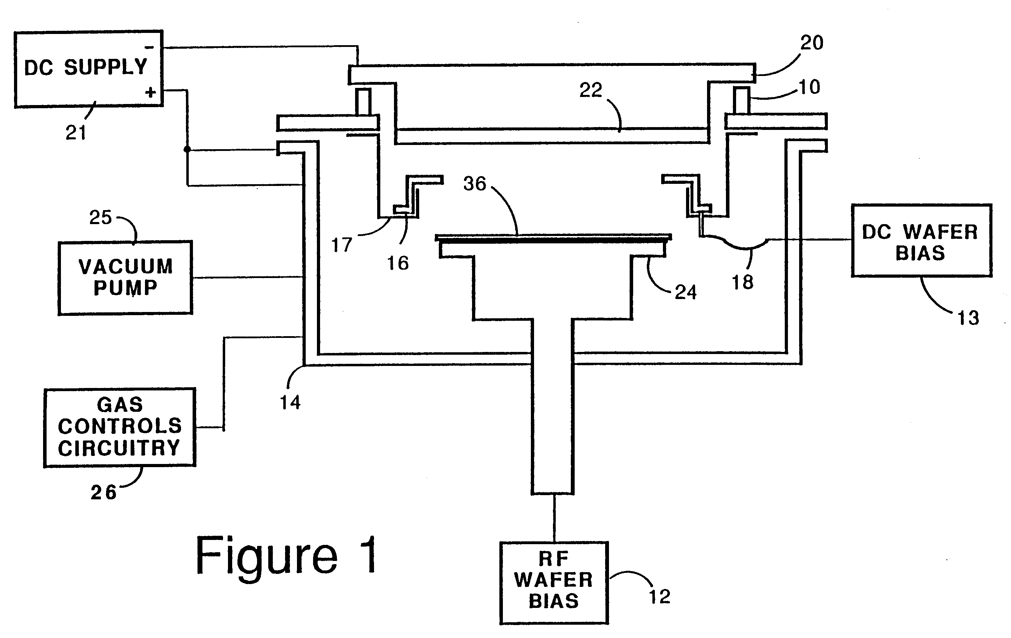

In Figure 1, a physical vapor deposition (PVD) chamber 14 includes a movable wafer table 24. During the course of processing a specimen, i.e., a wafer 36, is placed on wafer table 24. Wafer table 24 is raised through a clamping ring 16 and a shield 17 to a processing location. An RF wafer bias circuit 12 provides an RF bias voltage to the wafer. A DC wafer bias circuit 13 provides a DC bias to the wafer through a line 18.

Gas control circuitry 26 controls gas flow in and out of chamber 14. A vacuum pump 25 is used to create a vacuum in PVD chamber 14 during processing of wafers.

A source 20 has a sputter target 22 composed of, for example, Titanium-Tungsten alloy. Source 20 is electrically isolated from shield 17 and the rest of PVD chamber 14 by an insulator ring 10. A DC power supply 21 establishes a voltage potential between shield 17 and source 20. When wafers are being processed, the negative terminal of DC power supply 21 is connected to target 22. The positive terminal is grounded to PVD chamber 14. This operating mode is used because gaseous ions from plasma will be accelerated toward whatever surface is connected to the negative terminal of power supply 21. Thus ions in deposition plasma strike target 22 and cause sputtering of Titanium-Tungsten alloy onto wafer 36 on wafer table 24.

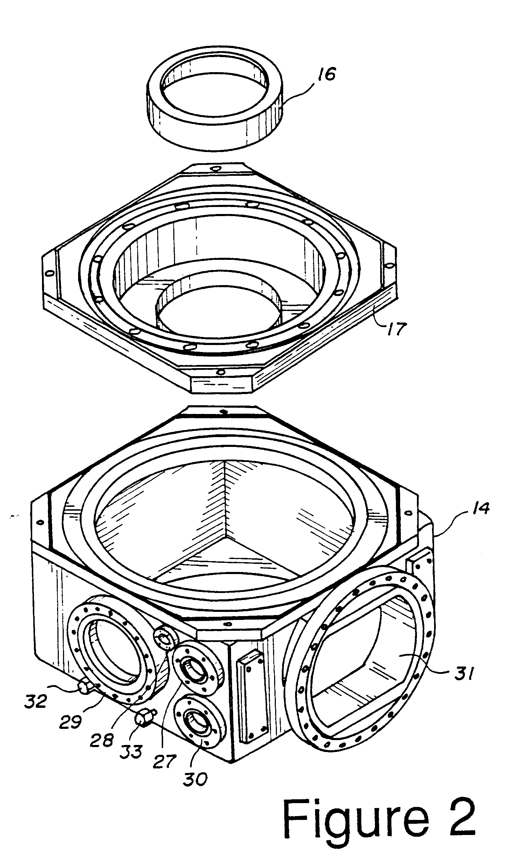

Fig. 2 shows PVD chamber 14, shield 17, and clamping ring 16. Chamber 14 is shown to include ports 27, 28, 29, 30, 31, 32, and 33. Port 30 may be used, for example, by vacuum pump 25 or by a roughing pump for initial pumping to create a vacuum. Port 33 may be, for example, used by a residual gas analyzer. Port 32 may be, for example, used to allow a power line into PVD chamber 14, for example, to power a lamp used in PVD. Port 27 may be, for example, used for venting. Port 29 may be, for example, used as a window. Port 28 may be, for example, used for supplying Argon gas and reactive gas into chamber 14. Wafers are placed in PVD chamber 14 through an opening 31 by automated machinery (not shown).

During sputter deposition onto a wafer, excess Titanium Tungsten (TiW) material is deposited on shield 17 and clamping ring 16. This material builds up and eventually begins to flake. The flaking results in unwanted particles contaminating PVD chamber 14. The present invention pertains to preparing the surface of shield 17 to increase adhesion of excess material to the shield.

The adhesion strength of TiW depends on both the bonding strength between the TiW and the material of which shield 17 is made, and it depends on the microstructure of the interface region between the TiW and shield 17.

To increase bonding strength, shield 17 may be sputter-etch cleaned before usage. The sputter-etch cleaning serves to loosen contamination which may form a diffusion barrier and prevent the TiW from bonding to shield 17. Also, the sputter-etch cleaning creates a high density of micro surface roughness. These defects allow for an increase in nucleation sites which minimize the formation of interface voids.

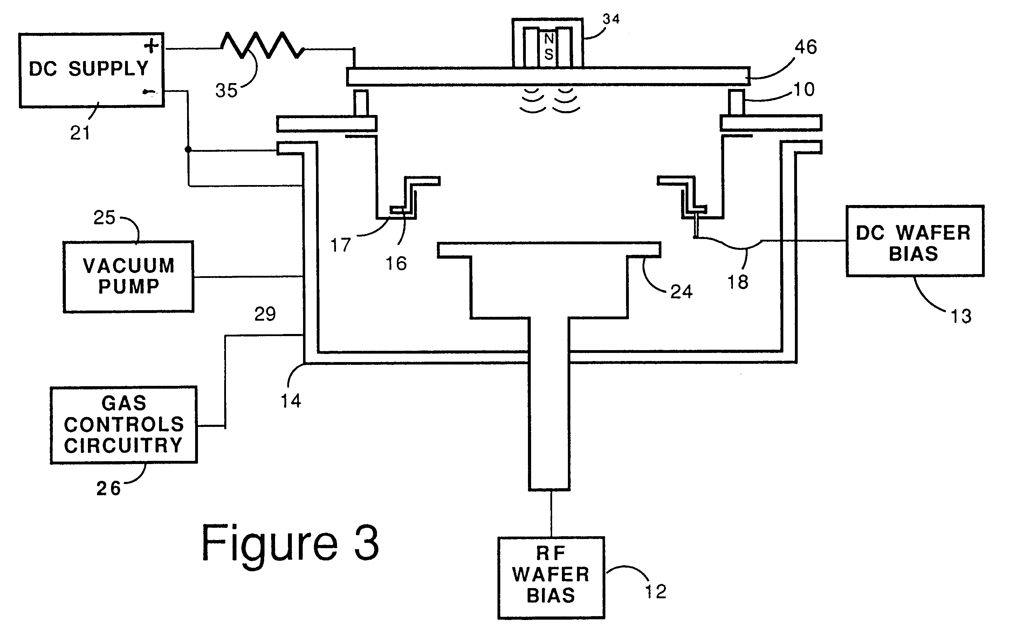

In the present invention, sputter-etch cleaning of the shields is done in a chamber from which source 20 is removed. As seen in Figure 3, source 20 is replaced with a flat cover plate 46 fabricated of aluminum alloy, stainless steel, or some other vacuum compatible metallic material. In the center of cover plate 46 is mounted an arrangement of permanent magnets 34 which does not exceed half of the chamber lid size in diameter. During the etch process, cover plate 46 is biased positive to a value between +300 volts and +1000 volts. Cover plate 46 thus becomes the anode of a glow discharge in the vacuum chamber. Power in the range of 50 Watts to 500 Watts is applied to cover plate 46. The negative terminal of power supply 21 is grounded to PVD chamber 14, shield 17 and clamping ring 16. The preferred operating ambient is 0.5 - 2 Pa (three to twelve Millitorr) of Argon.

Magnet assembly 34 is used to maintain plasma operation at the low operating pressures where the process is most efficient at etching the grounded shield 17 and clamping ring 16. Alternate means of striking the shield etch plasma include momentary application of high pressure in the range of 7-70 Pa (50 Millitorr to 500 Millitorr) and include the momentary application of a high voltage AC or DC. Two types of power supplies may be used to maintain the plasma. The first is a constant-power power supply with a rating of 1000 Volts and 1 kilowatt. The second is a 1000 Volt constant-voltage power supply used in conjunction with a high power ballast resistor 35.

At discharge powers of 250 Watts, shield 17 may typically be cleaned to a satisfactory degree after several minutes of the etch process.

For increased adhesion, before the sputter-etch cleaning of shield 17, shield 17 may be bead blasted. The bead blasting is done by bombarding shield 17 and clamping ring 16 with aluminum oxide abrasive powder. The bead blasting may be done in a commercially available sand blasting chamber.

The bead blasting makes the surface of shield 17 irregular. The irregular surface, on a microscopic scale, will enhance interface crack propagation of TiW material which is later deposited on shield 17. Thus, the surface irregularities will result in the breaking up of the deposited films into sections are small with respect to flake sizes. This significantly hinders flaking.

Making the surface of shield 17 rough, both through etching and bead blasting, increases adhesion due to purely mechanical effects. The rough surface provides a greater surface area. In addition, the rough surface distributes stress, that is, when one side of a ridge is in tensile stress, the other side of the ridge is in compression stress.

Selection of material for shield 17 and clamping ring 16 also is important to maximize adhesion. Shields made of Titanium, stainless steel covered with a film of Aluminum, Aluminum or Molybdenum have proved to provide satisfactory adhesion.

Further, designing of shield 17 and clamping ring 16 to maximize the surface on which excess TiW material is deposited reduces the thickness of the deposits.

Although the discussion of the preferred embodiment has focussed on increasing adhesion of TiW material to shield 17, the invention is applicable to increasing adhesion of other materials used in physical vapor deposition chamber. For instance, the invention may be used to increase adhesion from excess material from depositions of pure Tungsten or a reactive deposition of Titanium nitride.

Alternately to sputter etch cleaning, shield 17 and clamping ring 16 may be cleaned by gentle bombardment of a plasma (i.e., plasma cleaning) below the threshold and under process conditions where no shield etch material is physically removed. For example, the surface of shield 17 and clamping ring 16 may be reacted in an oxygen plasma to intentionally produce an oxide scale to which certain sputtered materials might readily adhere. Alternately, oxide scale on shield 17 and clamping ring 16 could be removed without the evolution of sputtered metal atoms through the action of a hydrogen plasma. Such reactive processes could be performed in situ in PVD chamber 14.

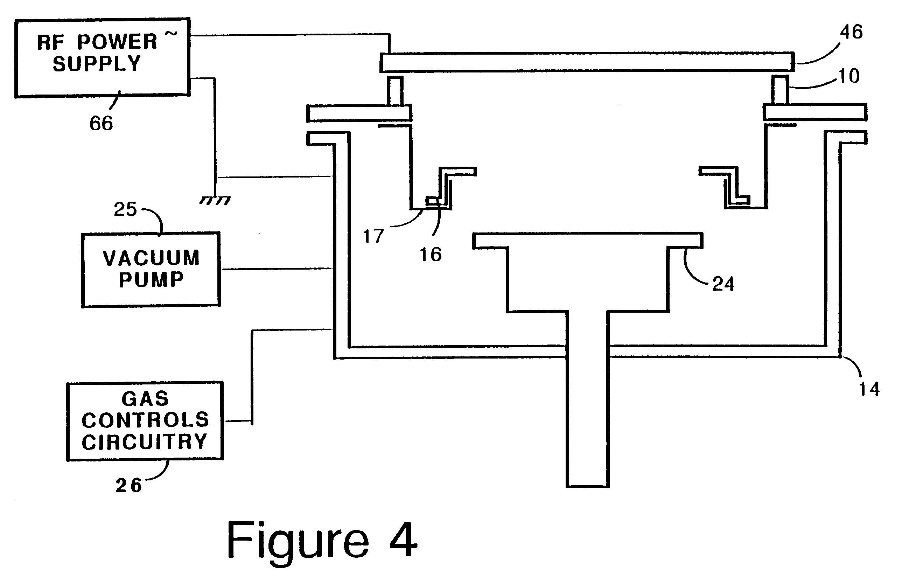

In Figure 4, PVD chamber 14 is shown modified to facilitate plasma cleaning. An RF power signal at an ISM frequency (e.g., 13.56 Megahertz) is applied to cover plate 46 of PVD chamber 14 by RF power supply 66. Typically for plasma cleaning, pressure inside PVD chamber 14 is 2,67Pa to 267Pa (20 Millitorr to 2 Torr), and the RF power signal generates power of 50 to 200 Watts. At such an elevated pressure, collisions would retard sputter evolution of metal from shield 17 and clamping ring 16.

Alternately to sputtering and to plasma cleaning, shield 17 and clamping ring 16 may be cleaned using a non-reactive desorption cleaning process. For example, shield 17 and clamping ring 16 may be bombarded with Argon at energies below the energy threshold at which sputtering will take place. Such a non-reactive desorption cleaning is useful to dislodge from shield 17 and clamping ring 16 adsorbed water and residual liquid or solid contamination which might remain after wet cleaning shield 17 and clamping ring 16.

Non-reactive desorption cleaning may, for example, be performed in situ in PVD chamber 14, when PVD chamber is arranged as shown in Figure 4. An RF power signal at an ISM frequency (e. g. 13.56 Megahertz) is applied to cover plate 46 of PVD chamber 14 by RF power supply 66. Inside PVD chamber 14 is an inert gas ambient such as Argon.

Alternately Helium, Neon, or Krypton could be used instead of Argon. When pressure inside PVD chamber 14 is 2,67 Pa to 267 Pa (20 Millitorr to 2 Torr), and the RF power signal generates power of 50 to 500 Watts, sufficient collisions would slow down plasma ions such that a high density could be built up with less than 10 electron-Volts of energy. The impact of the plasma ions on shield 17 and clamping ring 16 would desorb physisorbed species.

Plasma used in a reactive plasma process may come from generating reactive species in a separate upstream plasma preparation chamber. One advantage of such a method is that an upstream plasma preparation chamber may be considerably smaller than the parts that are processed.

## Claims

1. A method for sputter-etch cleaning of a shield (17) arranged in a physical vapor deposition chamber (14) housing a sputter source (20), the method comprising the steps of:
a) replacing said sputter source (20) by a plate (46); and
b) applying electrical power to said plate (46).

2. A method as in claim 1
using a DC power supply (21) having a first terminal (-) connected to said sputter source (20) and a second terminal (+) connected to said shield (17) during the deposition process, further comprising the step of
c) changing polarity by connecting said first terminal (-) to said shield (17) and connecting said second terminal (+) to said plate (46).

3. A method as in claim 1 or 2,
wherein a magnet (34) is placed on said plate (46).

4. A method of any of claims 1 to 3,
wherein said electrical power creates a plasma in said chamber (14).

5. A method for plasma-cleaning of a shield (17) arranged in a physical vapor deposition chamber (14) housing a sputter source (20), the method comprising the steps of:
a) replacing said sputter source (20) by a plate (46); and
b) applying R.F. power (66) between said shield (17) and said plate (46).

6. A method as in claim 5,
wherein said R. F. power (66) creates a plasma in said chamber (14).

7. A method as in claim 5 or 6,
wherein said shield (17) is reactive plasma cleaned in an H₂ or O₂ ambient.

8. A method as in claim 7,
wherein said H₂ or O₂ is activated in a separate upstream activation chamber.

9. A method as in claim 6,
wherein said shield (17) is cleaned by non-reactive desorption cleaning in a plasma formed of an inert gas, preferably argon at 2·67 to 267Pa and an R.F. power of 50 to 500 W essentially without sputtering.

10. A physical vapor deposition chamber (14) housing a sputter source (20, 22) and a shield (17) for surrounding a work piece and further connected to an electrical power supply means (21, 66),
**characterized** in
that there is provided a plate (46) replacing said sputter source allowing cleaning of said shield (17), and wherein said plate (46) is coupled to said power supply means (21; 66) for creating a plasma in said chamber (14) by applying a DC power signal between said plate (46) and said shield, opposite in polarity to a signal applied during the vapor deposition process.

11. A physical vapor deposition chamber as in claim 10,
**characterized** by
a magnet (34), coupled to said plate (46), and wherein preferably the magnet (34) is symmetrically centered on the plate (46) and a portion of the magnet (34) which is in contact with the plate (46) has a diameter which is about or less one half the diameter of the plate (46).

12. A physical vapor deposition chamber (14; 67) housing a sputter source (20, 22) and a shield (17) for surrounding a work piece and further connected to an electrical R. F. power supply means (66),
**characterized** in
that there is provided a plate (46) replacing said sputter source allowing cleaning of said shield (17), and wherein said plate (46) is coupled to said R. F. power supply means (66) for creating a plasma in said chamber (14) by applying an R.F. power signal, a magnet (34) being coupled to said plate (46) preferably symmetrically centered on the plate (46), a portion of the magnet (34) in contact with the plate (46) having a diameter which is about or less half the diameter of the plate (46).

## Patentansprüche

1. Ein Verfahren zum Sputterätzreinigen einer Abschirmung (17), die in einer eine Sputterquelle (20) enthaltenden Kammer (14) zum physikalischen Beschichten angeordnet ist, wobei das Verfahren die Schritte aufweist:
a) Ersetzen der Sputterquelle (20) durch eine Platte (46); und
b) Zuführen elektrischer Leistung zu der Platte (46).

2. Ein Verfahren nach Anspruch 1,
bei dem eine Gleichspannungsquelle (21) mit einer ersten Klemme (-), die mit der Sputterquelle (20) verbunden ist, und einer zweiten Klemme (+), die mit der Abschirmung (17) verbunden ist, während des Beschichtungsprozesses verwendet wird und das ferner den Schritt
c) Ändern der Polarität durch Verbinden der ersten Klemme (-) mit der Abschirmung (17) und Verbinden der zweiten Klemme (+) mit der Platte (46) aufweist.

3. Ein Verfahren nach Anspruch 1 oder 2,
wobei ein Magnet (34) auf der Platte (46) angeordnet ist.

4. Ein Verfahren nach irgendeinem der Ansprüche 1 bis 3,
wobei die elektrische Leistung ein Plasma in der Kammer (14) erzeugt.

5. Ein Verfahren zum Plasmareinigen einer Abschirmung (17), die in einer eine Sputterquelle (20) enthaltenden Kammer (14) zum physikalischen Beschichten angeordnet ist,
wobei das Verfahren die Schritte aufweist:
a) Ersetzen der Sputterquelle (20) durch eine Platte (46); und
b) Zuführen von Hochfrequenzleistung (66) zwischen die Abschirmung (17) und die Platte (46).

6. Ein Verfahren nach Anspruch 5,
wobei die Hochfrequenzleistung (66) in der Kammer (14) ein Plasma erzeugt.

7. Ein Verfahren nach Anspruch 5 oder 6,
wobei die Abschirmung (17) in einer H₂- oder O₂-Umgebung mittels eines reaktiven Plasmas gereinigt wird.

8. Ein Verfahren nach Anspruch 7,
wobei das H₂ oder das O₂ in einer getrennten, vorgeschalteten Aktivierungskammer aktiviert wird.

9. Ein Verfahren nach Anspruch 6,
wobei die Abschirmung (17) im wesentlichen ohne Sputtern mittels eines nicht-reaktiven Desorptionsreinigens in einem Plasma gereinigt wird, das aus einem inerten Gas, vorzugsweise Argon bei 2,67 bis 267 Pa und einer Hochfrequenzleistung von 50 bis 500 W ausgebildet wird.

10. Ein Kammer (14) zum physikalischen Beschichten, die eine Sputterquelle (20, 22) und eine Abschirmung (17) zum Umschließen eines Werkstücks enthält und ferner mit einer elektrischen Leistungsquelle (21, 66) verbunden ist,
dadurch **gekennzeichnet,**
daß eine Platte (46) vorgesehen ist, die die Sputterquelle ersetzt und ein Reinigen der Abschirmung (17) ermöglicht, wobei die Platte (46) mit der Leistungsquelleneinrichtung (21; 66) zum Erzeugen eines Plasmas in der Kammer (14) durch Zuführen eines Gleichspannungs-Leistungssignales mit einer entgegengesetzten Polarität zu einem während des Beschichtungsprozesses zugeführten Signal zwischen der Platte (46) und der Abschirmung gekoppelt ist.

11. Eine Kammer zum physikalischen Beschichten nach Anspruch 10,
**gekennzeichnet** durch,
einen Magneten (34), der mit der Platte (46) gekoppelt ist, wobei der Magnet (34) vorzugsweise auf der Platte (46) symmetrisch zentriert ist und ein mit der Platte (46) in Berührung stehendes Teil des Magneten (34) einen Durchmesser aufweist, der etwa der Hälfte des Durchmessers der Platte (46) oder weniger entspricht.

12. Eine Kammer (14; 67) zum physikalischen Beschichten, die ein Sputterquelle (20, 22) und eine Abschirmung (17) zum Umschließen eines Werkstücks enthält und ferner mit einer elektrischen Hochfrequenz-Leistungsquelleneinrichtung (66) verbunden ist,
dadurch **gekennzeichnet,**
daß eine Platte (46) vorgesehen ist, die die Sputterquelle ersetzt und ein Reinigen der Abschirmung (17) ermöglicht, wobei die Platte (46) mit der Hochfrequenz-Leistungsquelleneinrichtung (66) zum Erzeugen eines Plasmas in der Kammer (14) durch Zuführen eines Hochfrequenz-Leistungssignales gekoppelt ist, wobei ein Magnet (34) mit der Platte (46) vorzugsweise symmetrisch auf der Platte (46) zentriert gekoppelt ist, und wobei ein mit der Platte (46) in Berührung stehendes Teil des Magneten (34) einen Durchmesser aufweist, der etwa der Hälfte des Durchmessers der Platte (46) oder weniger entspricht.

## Revendications

1. Procédé pour nettoyer au moyen d'une attaque par pulvérisation cathodique un écran (17) qui est disposé dans une chambre (14) de dépôt en phase gazeuse par voie physique dans laquelle est logée une source de pulvérisation cathodique (20), le procédé comprenant les étapes selon lesquelles :
a) on remplace ladite source de pulvérisation cathodique (20) par une plaque (46) ; et :
b) on applique de l'énergie électrique à ladite plaque (46).

2. Procédé selon la revendication 1 qui utilise une alimentation en courant continu (21) dont une première borne (-) est reliée à ladite source de pulvérisation cathodique (20) et dont une deuxième borne (+) est reliée audit écran (17) pendant l'opération de dépôt, et qui comprend en outre l'étape selon laquelle :
c) on change la polarité en reliant ladite première borne (-) audit écran (17) et en reliant ladite deuxième borne (+) à ladite plaque (46).

3. Procédé selon la revendication 1 ou 2, dans lequel un aimant (34) est placé sur ladite plaque (46).

4. Procédé selon l'une quelconque des revendications 1 à 3, dans lequel ladite énergie électrique crée un plasma dans ladite chambre (14).

5. Procédé pour nettoyer par un plasma un écran (17) qui est disposé dans une chambre (14) de dépôt en phase gazeuse par voie physique dans laquelle est logée une source de pulvérisation cathodique (20), le procédé comprenant les étapes selon lesquelles :
a) on remplace ladite source de pulvérisation cathodique (20) par une plaque (46) ; et :
b) on applique de l'énergie à haute fréquence (66) entre ledit écran (17) et ladite plaque (46).

6. Procédé selon la revendication 5, dans lequel ladite énergie à haute fréquence (66) crée un plasma dans ladite chambre (14).

7. Procédé selon la revendication 5 ou 6, dans lequel ledit écran (17) est nettoyé par un plasma réactif dans une atmosphère de H₂ ou de O₂.

8. Procédé selon la revendication 7, dans lequel ledit H₂ ou O₂ est activé dans une chambre d'activation séparée située en amont.

9. Procédé selon la revendication 6, dans lequel ledit écran (17) est nettoyé par un nettoyage de désorption non réactive dans un plasma formé par un gaz inerte, et de préférence par de l'argon, sous une pression de 2,67 à 267 Pa et avec une puissance à haute fréquence de 50 à 500 watts, pour l'essentiel sans pulvérisation cathodique.

10. Chambre (14) de dépôt en phase gazeuse par voie physique dans laquelle sont logés une source de pulvérisation cathodique (20, 22) et un écran (17) pour entourer une pièce et qui est en outre reliée à des moyens d'alimentation en énergie électrique (21 ; 66), caractérisée par le fait qu'il est prévu une plaque (46) qui remplace ladite source de pulvérisation cathodique, ce qui permet le nettoyage dudit écran (17), et dans laquelle ladite plaque (46) est accouplée auxdits moyens d'alimentation en énergie (21 ; 66) pour créer un plasma dans ladite chambre (14) en appliquant entre ladite plaque (46) et ledit écran un signal de puissance en courant continu dont la polarité est opposée à celle d'un signal appliqué pendant l'opération de dépôt en phase vapeur.

11. Chambre de dépôt en phase gazeuse par voie physique selon la revendication 10, caractérisée par un aimant (34) qui est accouplé à ladite plaque (46), et dans laquelle l'aimant (34) est de préférence centré symétriquement sur la plaque (46), et une partie de l'aimant (34) qui est en contact avec la plaque (46) présente un diamètre qui est à peu près égal ou inférieur à la moitié du diamètre de la plaque (46).

12. Chambre (14 ; 67) de dépôt en phase gazeuse par voie physique dans laquelle sont logés une source de pulvérisation cathodique (20, 22) et un écran (17) pour entourer une pièce et qui est en outre reliée à des moyens d'alimentation en énergie électrique à haute fréquence (66), caractérisée par le fait qu'il est prévu une plaque (46) qui remplace ladite source de pulvérisation cathodique, ce qui permet le nettoyage dudit écran (17), et dans laquelle ladite plaque (46) est accouplée auxdits moyens d'alimentation en énergie à haute fréquence (66) pour créer un plasma dans ladite chambre (14) en appliquant un signal de puissance à haute fréquence, un aimant (34) étant accouplé à ladite plaque (46) en étant de préférence centré symétriquement sur la plaque (46), et une partie de l'aimant (34) qui est en contact avec la plaque (46) présentant un diamètre qui est à peu près égal ou inférieur à la moitié du diamètre de la plaque (46).
